# EUROPÄISCHE PATENTSCHRIFT

(11) **EP 4 214 525 B1**
(45) Veröffentlichungstag und Bekanntmachung des Hinweises auf die Patenterteilung: **29.10.2025**
(21) Anmeldenummer: 21769925.5
(22) Anmeldetag: 25.08.2021
(51) Int. Cl.: G01R 31/34, F04B 51/00, F04D 15/02, F04D 27/00, H02H 7/08

(54) **PUMPE MIT ÜBERWACHUNGSSCHALTUNG**
PUMP HAVING MONITORING CIRCUIT
POMPE DOTÉE D'UN CIRCUIT DE SURVEILLANCE

(30) Priorität: 16.09.2020 DE 202020105300 U; 07.04.2021 DE 202021101831 U
(43) Veröffentlichungstag der Anmeldung: 26.07.2023
(73) Patentinhaber: Brinkmann Pumpen K.H. Brinkmann GmbH & Co. KG, 58791 Werdohl (DE)
(72) Erfinder: WENDEROTT, Dirk, 44577 Castrop-Rauxel (DE); VEDRAL, Andreas, 44577 Castrop-Rauxel (DE)
(74) Vertreter: Ter Meer Steinmeister & Partner
(86) Internationale Anmeldenummer: PCT/EP2021/073478
(87) Internationale Veröffentlichungsnummer: WO 2022/058132

(56) Entgegenhaltungen:
- EP-A2- 0 984 292
- WO-A1-2015/187536
- CN-A- 111 365 253
- DE-A1- 10 205 966
- DE-A1- 102010 045 152
- DE-A1- 4 301 958
- FR-A1- 2 828 026

## Beschreibung

Die Erfindung betrifft eine Pumpe mit einem elektrischen Motor und einer in einem Gehäuseteil des Motors angeordneten elektronischen Überwachungsschaltung zur Überwachung und Aufzeichnung von Betriebsparametern der Pumpe, wobei einer der Betriebsparameter die Stromaufnahme der Pumpe ist und wobei die Überwachungsschaltung eine digitale, in einen Hableiterbaustein integrierte Messschaltung mit mindestens einem Hall-Sensor zur Strom-Messung aufweist.

Elektrische Pumpen werden beispielsweise bei Werkzeugmaschinen dazu eingesetzt, die Bearbeitungswerkzeuge und Werkstücke mit flüssigen Kühlschmierstoff zu versorgen, der dann wieder aufgefangen und, gegebenenfalls nach geeigneter Aufbereitung oder Filterung, wieder zur Saugseite der Pumpe zurückgeleitet wird.

Oft wird in einem Maschinenpark eine Vielzahl elektrischer Pumpen eingesetzt, die verschiedenste Aufgaben zu erfüllen haben und koordiniert miteinander und mit anderen Aggregaten des Maschinenparks zusammenarbeiten müssen. Eine Funktionsstörung oder ein Ausfall einer einzelnen Pumpe kann dann zu einem längeren Betriebsstillstand führen und erhebliche Kosten verursachen. Es ist deshalb erforderlich, die Pumpen und andere Komponenten des Maschinenparks regelmäßig zu warten. Auch eine engmaschige Überwachung und Wartung aller Komponenten der Anlage verursacht nicht unbeträchtliche Kosten.

Aus DE 43 01 958 A1 ist eine Pumpe mit einer integrierten Überwachungsschaltung der eingangs genannten Art bekannt.

Aus US 2016 076 536 A1 ist ein Kompressor bekannt, der eine Überwachungsschaltung zur Fernüberwachung von Betriebsparametern aufweist. Unter anderem wird auch die Stromaufnahme des Antriebsmotors überwacht.

Zur Messung der Stromaufnahme von mit Wechselstrom betriebenen elektrischen Aggregaten sind Stromsensoren in der Form von Rogowskispulen bekannt, die den stromdurchflossenen Leiter umgeben und in denen aufgrund des den Leiter umgebenden Magnetfelds eine von der Stromstärke abhängige Spannung induziert wird. Solche Stromsensoren sind jedoch verhältnismäßig kostspielig und außerdem sehr sperrig, so dass sie sich bei relativ kleinbauenden Pumpen wie beispielsweise Kühlschmierstoffpumpen kaum im oder am Motorgehäuse unterbringen lassen.

Aufgabe der Erfindung ist es, eine bessere Erkennung von Betriebsstörungen der Pumpe zu ermöglichen.

Diese Aufgabe wird erfindungsgemäß dadurch gelöst, dass dass die Messschaltung eine Strom- und Spannungsmessschaltung ist, und dass die Überwachungsschaltung dazu konfiguriert ist, mindestens einige der überwachten Parameter als Funktion der Zeit zu speichern.

Erfindungsgemäß werden die von der Überwachungsschaltung erfassten Betriebsparameter in einem lokalen Datenspeicher gespeichert und dann in gewissen Intervallen ausgelesen. Zur Strom-Messung werden Sensoren eingesetzt, die das Magnetfeld in der Umgebung des Leiters mit Hilfe des Hall-Effekts erfassen. Diese Sensoren lassen in einen Halbleiterbaustein (IC) integrieren, der von dem zu messenden Strom durchflossen wird und der zugleich die digitale Elektronik zur Auswertung des Messergebnisses enthält. Auf diese Weise lassen sich die Kosten und insbesondere der Platzbedarf für die Überwachungsschaltung so weit reduzieren, dass auch relativ kleine Pumpen mit einer integrierten Überwachungsschaltung ausgestattet werden können.

Vorteilhafte Ausgestaltungen und Weiterbildungen der Erfindung sind in den Unteransprüchen angegeben.

Zu den überwachten Betriebsparametern können neben der Stromaufnahme des Motors auch die Einschaltdauer der Pumpe sowie die Betriebsspannung gehören, so dass beispielsweise eine Anpassung der Wartungsintervalle an die tatsächliche Betriebsdauer der Pumpe ermöglicht wird und/oder Funktionsstörungen schneller erkannt werden können. Weitere Beispiele für relevante Betriebsparameter sind die Drehzahl der Pumpe, die Temperatur an verschiedenen Orten innerhalb des Motors und der Pumpe und/oder Beschleunigungen in allen drei Raumrichtungen, die Auskunft über etwaige Vibrationen oder Stöße während des Betriebs der Pumpe geben.

Die von der Überwachungsschaltung erfassten Betriebsparameter können in Echtzeit an eine Zentrale übermittelt und dort ausgewertet und aufgezeichnet werden.

Für die Echtzeitübermittlung der Daten an eine Zentrale kann die Überwachungsschaltung eine Schnittstelle für einen Datenbus oder Feldbus (z. B. Modbus) aufweisen. Ebenso können Anschlüsse für externe Messaufnehmer vorgesehen sein, beispielsweise zur Messung des Druckes und/oder Volumenstromes im Auslassstutzen der Pumpe.

Sämtliche Komponenten der Überwachungsschaltung lassen sich auf einer Platine anordnen, die sich in einem Klemmkasten unterbringen lässt, der Teil des Motorgehäuses bzw. des Motor/Pumpengehäuses ist.

Üblicherweise dient der Klemmkasten zur Aufnahme eines sogenannten Klemmbrettes, das sechs Kontaktstifte aufweist, die sich durch Brückenstecker paarweise miteinander verbinden lassen. An drei Kontaktstifte sind die drei Phasen des Stromversorgungskabels angeklemmt, während die drei übrigen Kontakte mit den Motorwicklungen verbunden sind. Durch Umstecken der Brückenstecker lässt sich dann wahlweise eine Sternschaltung oder Dreiecksschaltung der Motorwicklungen realisieren.

In einer Ausführungsform der Erfindung können auch diese Kontaktstifte oder wahlweise auch anders gestaltete Kontaktelemente unmittelbar auf der Platine angeordnet sein, so dass die Platine selbst zugleich die Funktion des Klemmbrettes übernehmen kann und somit eine noch raumsparendere Anordnung ermöglicht wird.

Im folgenden werden Ausführungsbeispiele anhand der Zeichnungen näher erläutert.

Es zeigen:
- Fig. 1: eine Ansicht einer elektrischen Pumpe;
- Fig. 2: ein Blockdiagramm einer elektronischen Überwachungsschaltung der Pumpe, und
- Fig. 3: eine Skizze einer Überwachungsschaltung gemäß einer anderen Ausführungsform.

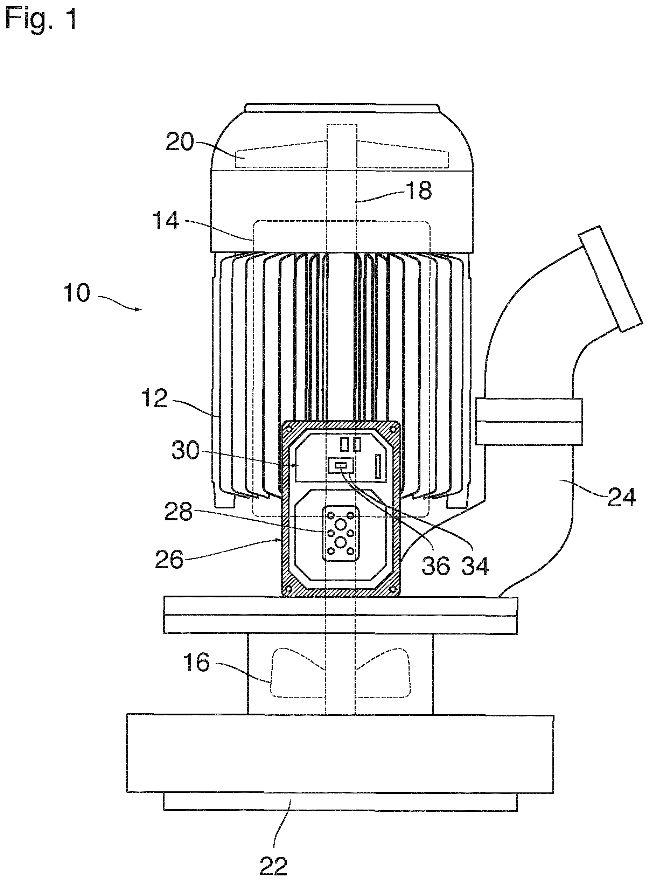

In Fig. 1 ist als Beispiel eine Pumpe mit einem Gehäuse 10 gezeigt, das in einem mit Kühlrippen 12 bestückten Abschnitt einen elektrischen Motor 14 und weiter unterhalb ein Pumpaggregat 16 aufnimmt. Der Motor und das Pumpaggregat sind auf einer gemeinsamen Welle 18 angeordnet, die am oberen Ende ein Lüfterrad 20 zur Kühlung des Motors trägt.

Am unteren Ende weist das Gehäuse 10 einen Ansaugöffnung 22 auf, über die eine zu pumpende Flüssigkeit, beispielsweise eine Kühlschmierstoffemulsion, angesaugt wird. Mit Hilfe des Pumpaggregats 16 wird die Flüssigkeit dann in ein Steigrohr 24 gefördert, das beispielsweise zu den Bearbeitungswerkzeugen einer Werkzeugmaschine führt.

Das Gehäuse 10 bildet an einer Stelle seines Umfangs, in Fig. 1 dem Betrachter zugewandt, einen Klemmkasten 26, der in bekannter Weise ein Klemmbrett 28 für die elektrischen Anschlüsse der Motorwicklungen aufnimmt. Der Klemmkasten 26 ist in Fig. 1 mit abgenommenem Deckel gezeigt, so dass das Innere des Klemmkastens erkennbar ist.

Neben dem Klemmbrett 28 ist in dem Klemmkasten eine elektronische Überwachungsschaltung 30 untergebracht, beispielsweise in der Form einer Platine, die mit elektronischen Bauelementen bestückt ist und über nicht gezeigte Leitungen mit den Anschlussklemmen des Motors verbunden und an ein Überwachungsnetzwerk angeschlossen ist.

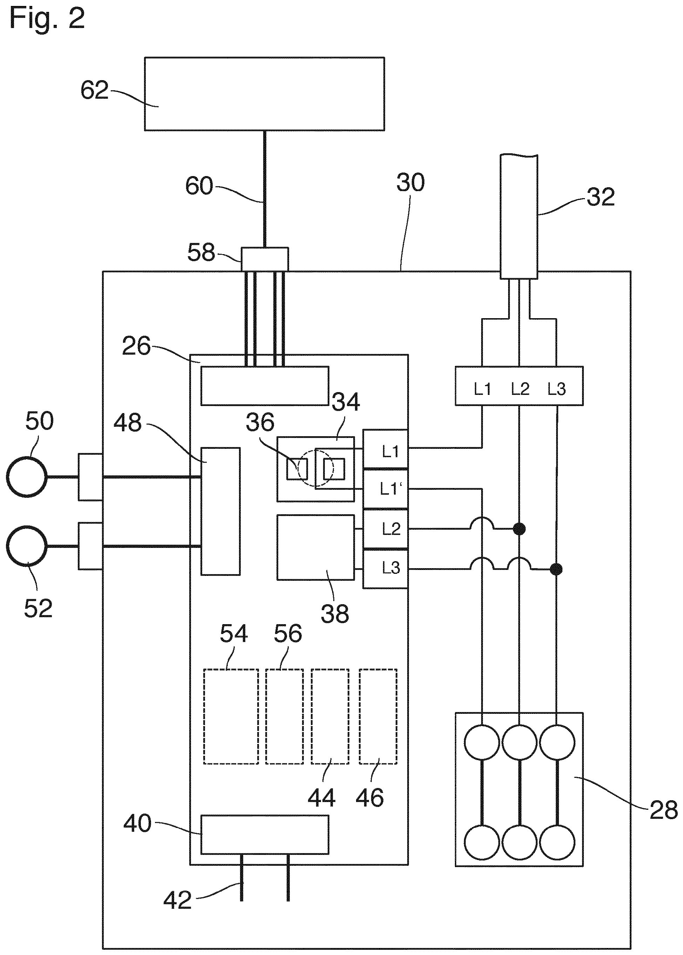

In Fig. 2 ist die Überwachungsschaltung 30 als Blockdiagramm dargestellt.

Eine von außen in den Klemmkasten 26 führende elektrische Zuleitung 32 für den Motor 14 hat drei Phasen L1, L2, L3. Mindestens eine der drei Phasen (z.B. L1; besser zwei oder alle drei) wird zur Strom- und Spannungsmessung durch eine digitale, in einen Halbleiterbaustein (IC) integrierte bzw. durch den Halbleiterbaustein gebildete Strom- und Spannungsmessschaltung 34 (Leistungsmessschaltung) geführt und dann als L1' mit der Klemmplatte 28 verbunden. Die Strom- und Spannungsmessschaltung 34 weist mehrere Hall-Sensoren 36 auf, die die Stromstärke anhand des von dem Strom erzeugten Magnetfelds messen. Die so gemessene Stromstärke wird in dem IC digital weiterverarbeitet, um alle relevanten Leistungsparameter (Wirkleistung, Scheinleistung, Blindleistung) zu bestimmen.

Die Phasen L2 und L3 sind direkt an das Klemmbrett 28 angeschlossen. Zur Messung der Spannungen der Phasen L2 und L3 ist jeweils eine Verbindung dieser Phasen vom der Klemmbrett 28 zu einer Spannungsmessschaltung 38 vorgesehen.

Über eine Schnittstelle 40 nimmt die Überwachungsschaltung Signale 42 von verschiedenen Temperaturfühlern auf, die die Temperatur an verschiedenen kritischen Stellen im Motor und/oder der Pumpe messen. Beispielsweise können die Innentemperatur im Klemmkasten 26 sowie die Wicklungstemperatur der Motorwicklungen gemessen werden.

Darüber hinaus weit die Überwachungsschaltung 30 einen Beschleunigungssensor 44 zur Messung etwaiger Beschleunigungen (Vibrationen) des Pumpengehäuses in allen drei Raumrichtungen sowie einen Schallsensor 46 zur Überwachung des Laufgeräusches der Pumpe auf.

Über eine weitere Schnittstelle 48 können unterschiedliche Sensoren 50, 52, wie beispielsweise Druck- ,Volumenstrom- oder auch Füllstandssensoren zur Messung wichtiger Prozessgrößen (Ausgangsdruck, Fördervolumen, Füllstand) über Leitungen mit der Überwachungsschaltung verbunden werden. Die Schnittstelle 48 enthält Analog/Digital-Wandler, mit denen die von den Sensoren übermittelten analogen Signale digitalisiert werden.

Die von der Überwachungsschaltung 30 erfassten Messdaten (Betriebsparameter), also die gemessenen Spannungen, Ströme, Temperaturen, Beschleunigungen, der Volumenstrom und der Druck, können innerhalb der Überwachungsschaltung 30 in einem nichtflüchtigen Speicher 54 zusammen mit zugehörigen Zeitstempeln gespeichert und von Zeit zu Zeit über eine RFID-Schnittstelle 56 ausgelesen werden.

Weiterhin ist die Überwachungsschaltung 30 dazu konfiguriert, eine gewisse Vorauswertung der erfassten Daten vorzunehmen, so dass etwaige Anomalien, die ein sofortiges Eingreifen des Wartungspersonals erfordern, unverzüglich erkannt werden können. Beispielsweise kann durch Vergleich der Stromaufnahme mit dem gemessenen Ausgangsdruck oder Volumenstrom eine übermäßig hohe Leckage oder gegebenenfalls auch ein Klemmen des Pumpaggregats festgestellt werden (beispielsweise verursacht durch in der Kühlschmierstoffemulsion enthaltene Späne).

Über eine Bus-Schnittstelle 58 und einen Datenbus 60 (Feldbus) ist die Auswertungsschaltung 30 mit einem Überwachungsnetzwerk oder einer Zentrale 62 verbunden, die gegebenenfalls auch die Überwachungsdaten weiterer Pumpen und sonstiger Aggregate auswertet. Sofern die Überwachungsschaltung 30 eine Anomalie feststellt, kann über den Datenbus 60 unverzüglich eine Warnmeldung an die Zentrale 62 gesendet werden. Wahlweise können die von den verschiedenen Messaufnehmern erfassten Daten auch in Echtzeit an die Zentrale 62 gemeldet und dann dort ausgewertet werden.

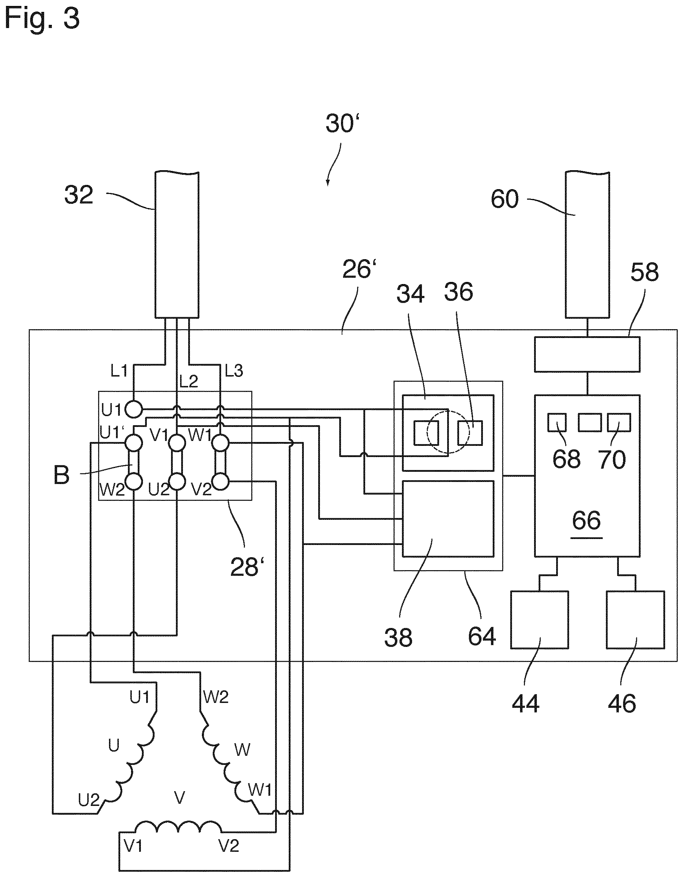

Fig. 3 zeigt eine Überwachungsschaltung 30' gemäß einer anderen Ausführungsform. Der wesentliche Unterschied gegenüber der zuvor beschriebenen Überwachungsschaltung 30 besteht darin, dass die Komponenten der Überwachungsschaltung auf einer Platine 26' angeordnet sind, die zugleich die Funktion eines Klemmbrettes 28' erfüllt.

Die drei Phasen L1, L2 und L3 der elektrischen Zuleitung 32 sind an drei Kontakte U1, V1 und W1 angeklemmt, die sich auf einem Bereich der Platine 26' befinden, der als Klemmbrett 28' fungiert. Der Kontakt U1 ist über die Strom- und Spannungsmessschaltung 34 mit einem weiteren Kontakt U1' verbunden. Die drei Kontakte U1', V1 und W1 sowie drei weitere Kontakte W2, U2 und V2 sind wie bei einem herkömmlichen Klemmbrett in gleichen Abständen in zwei parallelen Reihen angeordnet und lassen sich durch Brücken B in unterschiedlichen Konfigurationen miteinander verbinden.

In Fig. 3 sind außerdem schematisch drei Motorwicklungen U, V, W des Motors 14 gezeigt, die im gezeigten Beispiel in Dreiecksschaltung zwischen die Kontakte des Klemmbrettes 28' geschaltet sind. Zur Verdeutlichung sind die entgegengesetzten Enden jeder Motorwicklung mit den Bezugszeichen der Kontakte bezeichnet, mit denen sie verbunden sind. Durch Umstecken der Brücken B ließe sich wahlweise auch eine Sternschaltung der Motorwicklungen realisieren.

Obgleich die Spannung am Kontakt U1 auch mit der Strom- und Spannungsmessschaltung 34 gemessen werden kann, damit auch die Phasendifferenz zwischen Strom und Spannung erfasst werden kann, ist in diesem Ausführungsbeispiel die Spannungsmessschaltung 38 dazu ausgebildet, die Spannungen aller drei Phasen zu messen. Sie ist demgemäß elektrisch mit jedem der Kontakte U1, V1 und W1 verbunden. Die Strom- und Spannungsmessschaltung 34 und die Spannungsmessschaltung 38 bilden zusammen eine Leistungsmessschaltung 64, deren Messresultate in diesem Beispiel zur weiteren Auswertung an einen Mikroprozessor 66 übergeben werden. Der Mikroprozessor 66 wertet auch die Messergebnisse des Beschleunigungssensors 44 und des Schallsensors 46 sowie wahlweise die Signale weiterer Sensoren aus, die hier nicht gezeigt sind, da sie bereits im Zusammenhang mit Fig. 2 beschrieben wurden.

Die Bus-Schnittstelle 58 greift auf Daten aus unterschiedlich großen Speicherbereichen 68, 70 des Mikroprozessors zu, in denen die an die Zentrale 62 (Fig.2) zu übermittelnden Daten zwischengespeichert werden. Beispielsweise können in dem Speicherbereich 68 die relevantesten Überwachungsergebnisse in der Form relativ kurzer Bitfolgen gespeichert werden, die dann mit einem hohen Abfragetakt, also quasi in Echtzeit, an die Zentrale 62 übermittelt werden. Im Speicherbereich 70 können dagegen differenziertere Überwachungsergebnisse gespeichert werden, die einen größeren Datenumfang haben und, damit eine Überlastung des Busses 60 vermieden wird, in größeren Intervallen oder nur bei Bedarf übermittelt werden, beispielsweise nur dann, wenn der in Echtzeit übermittelte Inhalt des Speicherbereichs 68 auf das Vorliegen einer Störung hindeutet.

## Patentansprüche

1. Pumpe mit einem elektrischen Motor (14) und einer in einem Gehäuseteil (26) des Motors angeordneten elektronischen Überwachungsschaltung (30; 30') zur Überwachung und Aufzeichnung von Betriebsparametern der Pumpe, wobei einer der Betriebsparameter die Stromaufnahme der Pumpe ist, und wobei die Überwachungsschaltung (30; 30') eine digitale, in einen Halbleiterbaustein integrierte Messschaltung mit mindestens einem Hall-Sensor (36) zur Strom-Messung aufweist, **dadurch gekennzeichnet, dass** die Messschaltung eine Strom- und Spannungsmessschaltung (34) ist und dass die Überwachungsschaltung (30; 30') dazu konfiguriert ist, mindestens einige der überwachten Parameter als Funktion der Zeit zu speichern.

2. Pumpe nach Anspruch 1, bei der der Gehäuseteil, der die Überwachungsschaltung (30) aufnimmt, ein Klemmkasten (26) der Pumpe ist.

3. Pumpe nach Anspruch 1 oder 2, bei der die Überwachungsschaltung (30) dazu konfiguriert ist, neben der Stromaufnahme des Motors einen oder mehrere der folgenden Betriebsparameter zu messen:
- Betriebsspannung des Motors
- Temperatur im Gehäuseteil (26) und/oder an mindestens einer Stelle des Motors oder der Pumpe
- Volumenstrom der Pumpe
- Ausgangsdruck der Pumpe
- mechanische Beschleunigung des Pumpengehäuses
- das von einem Schallsensor (46) aufgenommene Laufgeräusch der Pumpe.

4. Pumpe nach einem der vorstehenden Ansprüche, bei der die Überwachungsschaltung (30; 30') eine RFID-Schnittstelle (50) zum Auslesen des Speicherinhalts aufweist.

5. Pumpe nach einem der vorstehenden Ansprüche, bei der die Überwachungsschaltung (30) eine Bus-Schnittstelle (52) zur Übermittlung von Daten an ein externes Überwachungsnetzwerk oder eine Überwachungszentrale (62) aufweist.

6. Pumpe nach einem der vorstehenden Ansprüche, bei der die Komponenten der Überwachungsschaltung (30') und Kontakte (U1', V1, W1, W2, U2, V2) eines Klemmbrettes (28') auf einer gemeinsamen Platine (26') angeordnet sind.

## Claims

1. A pump having an electric motor (14) and an electronic monitoring circuit (30; 30')) arranged in a housing part (26) of the motor, for monitoring and recording operating parameters of the pump, one of the operating parameters being the current consumption of the pump, wherein the monitoring circuit (30; 30') has a digital measuring circuit (34) which is integrated in a semiconductor component and has at least one Hall sensor (36) for measuring current, **characterized in that** the measuring circuit is a voltage and current measuring circuit (34) and the monitoring circuit (30; 30') is configured for storing at least some of the monitored parameters as a function of time.

2. The pump according to claim 1, wherein the housing part that accommodates the monitoring circuit (30) is a terminal box (26) of the pump.

3. The pump according to claim 1 or 2, wherein the monitoring circuit (30) is configured for measuring the following operating parameters in addition to the current consumption of the motor:
- operating voltage of the motor
- temperature in the housing part (26) and/or at at least one location in the motor or the pump
- volume flow rate of the pump
- output pressure of the pump
- mechanical acceleration of the pump housing
- the running noise of the pump as captured by an acoustic sensor (46).

4. The pump according to any of the preceding claims, wherein the monitoring circuit (30; 30') includes an RIFD interface (50) for reading the memory contents.

5. The pump according to any of the preceding claims, wherein the monitoring circuit (30) has a bus interface (52) for transmitting data to an external monitoring network or a central monitoring unit (62).

6. The pump according to any of the preceding claims, wherein the components of the monitoring circuit (30') and contacts (U1', V1, W1, W2, U2, V2) of a terminal board (28') are arranged on a common circuit board (26').

## Revendications

1. Pompe comportant un moteur électrique (14) et un circuit de surveillance électronique (30 ; 30') agencé dans une partie de carter (26) du moteur pour surveiller et enregistrer des paramètres de fonctionnement de la pompe, dans laquelle l'un des paramètres de fonctionnement est la consommation de courant de la pompe, et dans laquelle le circuit de surveillance (30 ; 30') comporte un circuit de mesure numérique intégré dans un composant à semi-conducteur, ayant au moins un capteur à effet Hall (36) pour la mesure de courant, **caractérisée en ce que** le circuit de mesure est un circuit de mesure de courant et de tension (34) et **en ce que** le circuit de surveillance (30 ; 30') est configuré pour mémoriser au moins certains des paramètres surveillés en fonction du temps.

2. Pompe selon la revendication 1, dans laquelle la partie de carter qui reçoit le circuit de surveillance (30) est une boîte à bornes (26) de la pompe.

3. Pompe selon la revendication 1 ou 2, dans laquelle le circuit de surveillance (30) est configuré pour mesurer, en plus de la consommation de courant du moteur, un ou plusieurs des paramètres de fonctionnement suivants :
- tension de fonctionnement du moteur,
- température dans la partie de carter (26) et/ou à au moins un endroit du moteur ou de la pompe,
- débit volumétrique de la pompe,
- pression de sortie de la pompe,
- accélération mécanique du carter de pompe,
- bruit de fonctionnement de la pompe enregistré par un capteur de son (46).

4. Pompe selon l'une des revendications précédentes, dans laquelle le circuit de surveillance (30 ; 30') comporte une interface RFID (50) pour lire le contenu de la mémoire.

5. Pompe selon l'une des revendications précédentes, dans laquelle le circuit de surveillance (30) comporte une interface bus (52) pour transmettre des données à un réseau de surveillance externe ou à une centrale de surveillance (62).

6. Pompe selon l'une des revendications précédentes, dans laquelle les composants du circuit de surveillance (30') et des contacts (U1', V1, W1, W2, U2, V2) d'une plaque à bornes (28') sont disposés sur une carte commune (26').
